# EUROPEAN PATENT APPLICATION

(11) **EP 4 361 899 A1**
(43) Date of publication of application: **01.05.2024**
(21) Application number: 23187814.1
(22) Date of filing: 26.07.2023
(51) Int. Cl.: G06N 5/01

(54) **EVALUATION SUPPORT PROGRAM, EVALUATION SUPPORT METHOD, AND INFORMATION PROCESSING APPARATUS**

(30) Priority: 31.10.2022 JP 2022175149
(71) Applicant: FUJITSU LIMITED, Kawasaki-shi, Kanagawa 211-8588 (JP)
(72) Inventor: IMAMURA, Satoshi, Kawasaki-shi, Kanagawa, 211-8588 (JP)
(74) Representative: Hoffmann Eitle

(57) **Abstract**

An evaluation program for causing a computer to perform processing including: executing optimization including iteratively performing a search and update for each variable in a target problem, the search including searching for a candidate for a solution to the variable, the update including updating a provisional value of the solution with the candidate when a difference between evaluation values of the provisional value and the candidate is equal to or smaller than a first threshold, and updating the provisional value with the candidate stochastically when the difference is greater than the first threshold; in the optimization, counting the number of times that the difference becomes equal to or greater than a second threshold before the last step in which the provisional value is updated with the candidate; and after the optimization, evaluating an appropriateness of the optimization for the target problem based on the counted number of times.

## Description

### FIELD

Embodiments discussed herein are related to an evaluation support program, an evaluation support method, and an information processing apparatus.

### BACKGROUND

Heretofore, there has been optimization processing of iterating a step including determining a candidate value of the solution to each of variables representing a target problem and controlling whether or not to update a provisional value of the solution to the variable with the candidate value based on a difference between evaluation values of the provisional value and the candidate value for the solution to the variable. This optimization processing is referred to as, for example, a simulated annealing (SA) method. The evaluation value is referred to as, for example, an energy. For example, in the SA method, if the difference between the evaluation values of the provisional value and the candidate value for the solution to a certain variable is equal to or less than 0, the provisional value of the solution to the variable is updated with the candidate value, and if the difference is greater than 0, the provisional value of the solution to the variable is updated with the candidate value stochastically by using a random number.

As related art, for example, there is a technique for calculating a provisional optimal solution to a combinatorial optimization problem by searching for a ground state of an Ising model obtained by converting the combinatorial optimization problem. For example, in a case where a combinatorial optimization problem is a minimization problem, there is a technique for calculating a lower bound of a minimization target in the minimization problem by solving a relaxation problem generated from the combinatorial optimization problem. For example, there is a technique for improving the speed and accuracy of quantum annealing by using a perturbation such as noise. For example, there is a quantum computing technique for solving a combinatorial optimization problem.

Japanese Laid-open Patent Publication No. 2020-194273, International Publication Pamphlet No. WO 2022/003943, and U.S. Patent Application Publication Nos. 2019-0102353 and 2020-0090071 are disclosed as the related art.

### SUMMARY

### TECHNICAL PROBLEM

However, in the related art, it is difficult to evaluate the appropriateness of the SA method for a target problem. For example, unless an evaluator knows characteristics of a target problem in detail, the evaluator has no way to determine whether or not it is suitable to apply the SA method to the target problem.

In one aspect, an object of the present disclosure is to facilitate an evaluation of the appropriateness of the SA method for a target problem.

### SOLUTION TO PROBLEM

According to an aspect of the embodiments, there is provided an evaluation program comprising instructions which when executed by a computer, cause the computer to perform processing comprising: executing optimization processing of iterating a step of performing a search process and an update process for each variable that represents a target problem, in which the search process includes searching for a candidate value for a solution to the variable that represents the target problem, and in which the update process includes updating a provisional value of the solution to the variable with the candidate value when a difference between evaluation values of the provisional value and the candidate value for the solution to the variable is equal to or smaller than a first threshold, and updating the provisional value of the solution to the variable with the candidate value stochastically by using a random number when the difference between the evaluation values of the provisional value and the candidate value for the solution to the variable is greater than the first threshold; in executing the optimization processing, counting the number of times that the difference between the evaluation values of the provisional value and the candidate value for the solution to the variable that represents the target problem becomes equal to or greater than a second threshold depending on a resolution of an integer value for generating the random number before the last step in which the provisional value of the solution to at least one variable that represents the target problem is updated with the candidate value; and after executing the optimization processing, evaluating an appropriateness of the optimization processing for the target problem based on the counted number of times.

### ADVANTAGEOUS EFFECTS OF INVENTION

According to one aspect, it is possible to facilitate an evaluation of the appropriateness of the SA method for a target problem.

### BRIEF DESCRIPTION OF DRAWINGS

FIG. 1 is an explanatory diagram illustrating an example of an evaluation support method according to an embodiment;
FIG. 2 is a block diagram illustrating a hardware configuration example of an information processing apparatus;
FIG. 3 is a block diagram illustrating a functional configuration example of the information processing apparatus;
FIG. 4 is an explanatory diagram illustrating an example of evaluating the appropriateness of the SA method for a maximum cut problem;
FIG. 5 is an explanatory diagram illustrating an example of evaluating the appropriateness of the SA method for a traveling salesman problem;
FIG. 6 is an explanatory diagram illustrating an example of a relationship between solution accuracy of the SA method and a difference evaluation skip count;
FIG. 7 is a flowchart illustrating an example of a solving processing procedure; and
FIG. 8 is a flowchart illustrating an example of an evaluation processing procedure.

### DESCRIPTION OF EMBODIMENTS

Hereinafter, embodiments of an evaluation support program, an evaluation support method, and an information processing apparatus according to the present disclosure will be described in detail with reference to the drawings.

### (Example of Evaluation Support Method According to Embodiment)

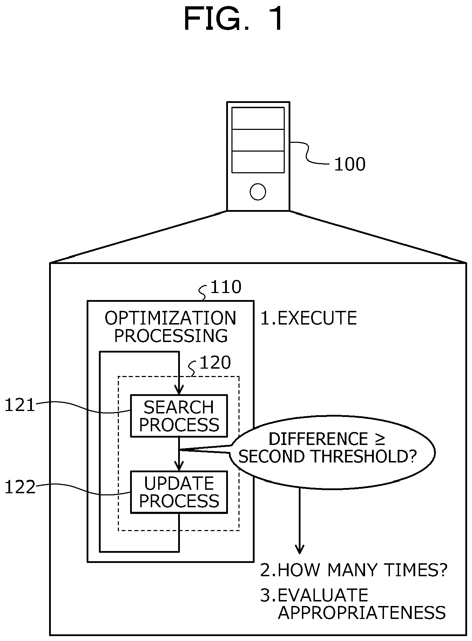

FIG. 1 is an explanatory diagram illustrating an example of an evaluation support method according to an embodiment. An information processing apparatus 100 is a computer for facilitating an evaluation of the appropriateness of the SA method for a target problem. For example, the information processing apparatus 100 is a server, a personal computer (PC), or the like.

The target problem is an optimization problem. For example, the target problem is represented by using multiple variables. Examples of the target problem include a maximum cut problem for determining how to divide a graph, a traveling salesman problem for searching for a travel route that minimizes the traveling cost, and the like. For example, the target problem may be solved by using a method other than the SA method, such as an exact solver for obtaining an exact solution with guaranteed optimality or a dedicated solver developed dedicated to the target problem.

For example, the SA method has a characteristic of being capable of solving a target problem at a higher speed than other optimization methods. Examples of the other optimization methods are optimization methods each using an exact solver, a dedicated solver, or the like. For example, the SA method is characterized in that a calculation time hardly becomes enormous even for a large-scale target problem.

However, it is difficult to evaluate the appropriateness of the SA method for a target problem. For example, the appropriateness indicates the accuracy with which the SA method will solve a target problem. For example, in the case of solving a target problem by using the SA method, it is difficult to appropriately evaluate how accurately the SA method will obtain a solution to each of the variables representing the target problem. For example, the variables representing a target problem are variables representing an objective function corresponding to the target problem.

For example, it is conceivable that, according to a rule of thumb, an expert in the field to which a target problem belongs determines whether or not it is suitable to apply the SA method to the target problem and evaluates the appropriateness of the SA method for the target problem. However, when an evaluator is not an expert and does not know detailed characteristics of a target problem, the evaluator has no way to determine whether or not it is suitable to apply the SA method to the target problem and evaluate the appropriateness of the SA method for the target problem.

For example, a method is conceivable which includes evaluating the appropriateness of the SA method for a target problem by comparing a case where the target problem is actually solved by using an exact solver with a case where the target problem is actually solved by using the SA method. This method fails to evaluate the appropriateness of the SA method for a target problem in a situation where the scale of the target problem is so large that it is difficult to solve the target problem by using the exact solver. Since this method includes solving a target problem by using the exact solver, a processing load and a processing time for evaluating the appropriateness of the SA method for the target problem may increase in some cases.

For example, a method is conceivable which includes exhaustively calculating values of an objective function corresponding to a target problem, and evaluating the appropriateness of the SA method for the target problem based on a distribution of the values of the objective function. In this conceivable method, for example, the appropriateness of the SA method for the target problem is rated high when the distribution of the values of the objective function is continuous, or the appropriateness of the SA method for the target problem is rated low when the distribution of the values of the objective function is discrete. Since this method includes exhaustively calculating the values of an objective function corresponding to a target problem, the processing load and the processing time for evaluating the appropriateness of the SA method for the target problem may increase in some cases.

To address these, an evaluation support method capable of facilitating an evaluation of the appropriateness of the SA method for a target problem will be described in the present embodiment.

The information processing apparatus 100 executes predetermined optimization processing 110 on a target problem in FIG. 1. For example, the predetermined optimization processing 110 is a method of obtaining a solution to each of variables representing the target problem by iterating a step 120 of performing a search process 121 and an update process 122 for each variable. The search process 121 is a process of searching for a candidate value for the solution to the variable representing the target problem. For example, in the search process 121, a random value is set as the candidate value for the solution to the variable representing the target problem.

For example, the update process 122 is a process of updating a provisional value of the solution to the variable representing the target problem with the candidate value. For example, in the update process 122, the provisional value of the solution to the variable is updated with the candidate value when a difference between evaluation values of the provisional value and the candidate value for the solution to the variable representing the target problem is equal to or smaller than a first threshold. For example, the first threshold is set in advance by a user. For example, the first threshold is 0. The evaluation value is, for example, an energy expressed by an energy function called an Ising model.

For example, the update process 122 is a process of stochastically updating the provisional value of the solution to the variable representing the target problem with the candidate value by using a random number when the difference between the evaluation values of the provisional value and the candidate value for the solution to the variable is greater than the first threshold. For example, the random number is generated based on an integer value for generating the random number. The integer value is set in advance, for example.

For example, in the update process 122, when the difference between the evaluation values of the provisional value and the candidate value for the solution to the variable representing the target problem is greater than the first threshold, a parameter whose value increases as the number of previously-iterated steps 120 increases is acquired. For example, in the update process 122, a product of the acquired parameter and the difference between the evaluation values of the provisional value and the candidate value for the solution to the variable representing the target problem is set as an evaluation value of the difFerence.

For example, in the update process 122, the provisional value of the solution to the variable is updated with the candidate value when the evaluation value of the difference between the evaluation values of the provisional value and the candidate value for the solution to the variable representing the target problem is equal to or greater than the random number. For example, in the update process 122, the provisional value of the solution to the variable is not updated with the candidate value when the evaluation value of the difference between the evaluation values of the provisional value and the candidate value for the solution to the variable representing the target problem is smaller than the random number. For example, the predetermined optimization processing 110 is the SA method.

(1-2) When executing the predetermined optimization processing 110, the information processing apparatus 100 counts the number of times that the difference between the evaluation values of the provisional value and the candidate value for the solution to the variable representing the target problem becomes equal to or greater than a second threshold. The second threshold is variable. For example, the second threshold is a threshold depending on a resolution of the integer value for generating the random number. The resolution specifies, for example, a maximum exponent of a reciprocal of a natural logarithm expressible by an integer value. For example, the second threshold is set based on the number of previously-iterated steps 120. For example, the second threshold is set to a quotient of the resolution divided by the parameter whose value increases as the number of previously-iterated steps 120 increases. For example, the information processing apparatus 100 counts the number of times that the difference between the evaluation values of the provisional value and the candidate value for the solution to the variable representing the target problem becomes equal to or greater than the second threshold before the last step 120 in which the provisional value of the solution to at least one of the variables representing the target problem is updated with the candidate value.

For example, the information processing apparatus 100 prepares a counter. For example, the counter is set to an initial value 0. For example, in each step 120 of the predetermined optimization processing 110, the information processing apparatus 100 increments the value of the counter every time the difference between the evaluation values of the provisional value and the candidate value for the solution to the variable representing the target problem is equal to or greater than the second threshold. For example, in each step 120 of the predetermined optimization processing 110, the information processing apparatus 100 outputs the value of the counter if the provisional value of the solution to the variable representing the target problem is updated with the candidate value. For example, after executing the predetermined optimization processing 110, the information processing apparatus 100 sets the lastly output value of the counter as the number of times that the difference between the evaluation values of the provisional value and the candidate value for the solution to the variable representing the target problem becomes equal to or greater than the second threshold, thereby counting the number of times. In this way, the information processing apparatus 100 may obtain the information to serve as a guide for evaluating the appropriateness of the predetermined optimization processing 110 for the target problem.

(1-3) After executing the predetermined optimization processing 110, the information processing apparatus 100 evaluates the appropriateness of the predetermined optimization processing 110 for the target problem based on the counted number of times. For example, the information processing apparatus 100 rates the predetermined optimization processing 110 inappropriate for the target problem when the counted number of times is equal to or smaller than a third threshold, or rates the predetermined optimization processing 110 appropriate for the target problem when the counted number of times is greater than the third threshold. For example, the third threshold is set in advance by the user. For example, the third threshold is 0.

In this way, the information processing apparatus 100 may facilitate an evaluation of the appropriateness of the predetermined optimization processing 110 for a target problem. For example, the information processing apparatus 100 may facilitate an evaluation of the appropriateness of the SA method for the target problem. For example, the information processing apparatus 100 may suppress increases in the processing load and the processing time for evaluating the appropriateness of the SA method for a target problem.

For example, the information processing apparatus 100 may enable a user to evaluate the appropriateness of the SA method for a target problem even when the user is not an expert and does not know detailed characteristics of the target problem. For example, the information processing apparatus 100 may suppress increases in the processing load and the processing time for evaluating the appropriateness of the SA method for a target problem, and facilitate an evaluation of the appropriateness of the SA method for the target problem. For example, even when a target problem is of a large scale, the information processing apparatus 100 may facilitate an evaluation of the appropriateness of the SA method for the target problem.

Although the above description is provided for the case where the information processing apparatus 100 operates alone, embodiments are not limited to this. For example, there may be a case where the information processing apparatus 100 cooperates with another computer. For example, there may be a case where multiple computers cooperate with each other to implement the functions as the information processing apparatus 100. For example, there may be a case where the functions as the information processing apparatus 100 are implemented over a cloud.

Although the above description is provided for the case where the information processing apparatus 100 does not skip the update process 122 for any of the variables representing a target problem in each step 120 of the predetermined optimization processing 110, embodiments are not limited to this. For example, there may be a case where the information processing apparatus 100 skips the update process 122 for any of the variables representing a target problem in a certain step 120 of the predetermined optimization processing 110.

For example, in a step 120 of the predetermined optimization processing 110, when the difference between the evaluation values of the provisional value and the candidate value for the solution to the variable representing the target problem is equal to or greater than the second threshold, the information processing apparatus 100 may skip the update process 122 for the variable. In this way, the information processing apparatus 100 may reduce the processing load and the processing time for the predetermined optimization processing 110.

### (Application Examples of Information Processing Apparatus 100)

Next, application examples of the information processing apparatus 100 will be described. For example, the information processing apparatus 100 is applicable to a delivery business. For example, the information processing apparatus 100 may evaluate the appropriateness of the SA method for a vehicle routing problem for searching for travel routes of delivery trucks to travel from a base site to all delivery destinations. Therefore, for example, when the information processing apparatus 100 determines the SA method as appropriate for the vehicle routing problem, the information processing apparatus 100 may enable an operator of the delivery business to recognize that the accuracy of the travel routes obtained by the SA method is relatively high. Thus, the information processing apparatus 100 may make it easy for the operator of the delivery business to psychologically accept the travel routes obtained by the SA method, for example. For example, when the information processing apparatus 100 determines the SA method as inappropriate for the vehicle routing problem, the information processing apparatus 100 may enable the operator of the delivery business to recognize that it is suitable to solve the vehicle routing problem by a method other than the SA method.

For example, the information processing apparatus 100 may solve the vehicle routing problem by a method other than the SA method based on a result of evaluating the appropriateness of the SA method for the vehicle routing problem. For example, when determining the SA method as inappropriate for the vehicle routing problem, the information processing apparatus 100 may solve the vehicle routing problem by using an exact solver or a dedicated solver. Consequently, the information processing apparatus 100 may enable the operator of the delivery business to refer to the travel routes with relatively high accuracy.

For example, the information processing apparatus 100 is also applicable to an education field. For example, the information processing apparatus 100 may evaluate the appropriateness of the SA method for a combinatorial optimization problem for searching for a school time schedule. Therefore, when the information processing apparatus 100 determines the SA method as appropriate for the combinatorial optimization problem for searching for the school time schedule, the information processing apparatus 100 may enable a teacher to recognize that the accuracy of the school time schedule obtained by the SA method is relatively high. Thus, the information processing apparatus 100 may make it easy for the teacher to psychologically accept the school time schedule obtained by the SA method, for example. For example, when the information processing apparatus 100 determines the SA method as inappropriate for the combinatorial optimization problem for searching for the school time schedule, the information processing apparatus 100 may enable the teacher to recognize that it is suitable to solve the combinatorial optimization problem for searching for the school time schedule by a method other than the SA method.

For example, the information processing apparatus 100 may solve the combinatorial optimization problem for searching for the school time schedule by a method other than the SA method based on a result of evaluating the appropriateness of the SA method for the combinatorial optimization problem. For example, when determining the SA method as inappropriate for the combinatorial optimization problem for searching for the school time schedule, the information processing apparatus 100 may solve the combinatorial optimization problem by using an exact solver or a dedicated solver. Consequently, the information processing apparatus 100 may enable the teacher to refer to the school time schedule with relatively high accuracy.

### (Hardware Configuration Example of Information Processing Apparatus 100)

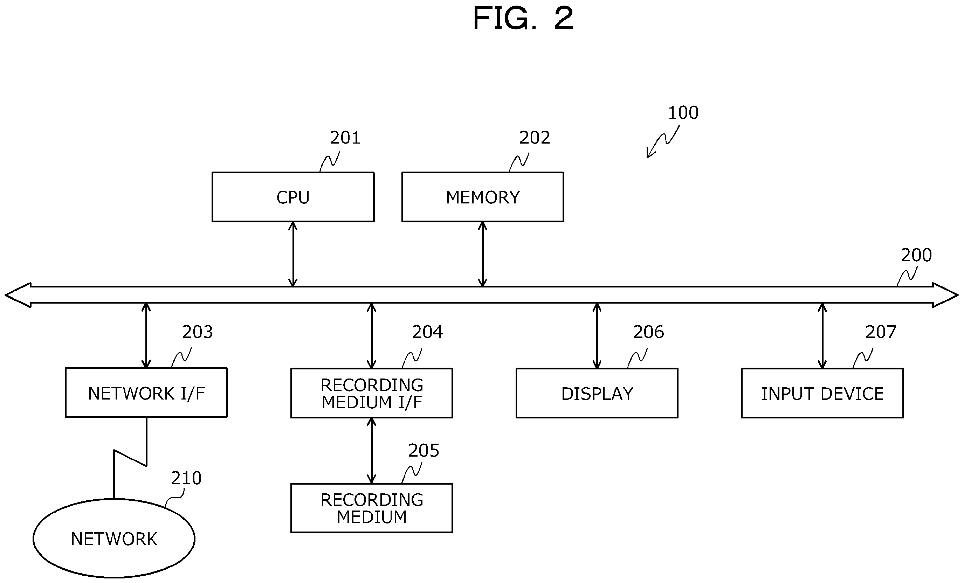

Next, a hardware configuration example of the information processing apparatus 100 will be described using FIG. 2.

FIG. 2 is a block diagram illustrating a hardware configuration example of the information processing apparatus 100. In FIG. 2, the information processing apparatus 100 includes a central processing unit (CPU) 201, a memory 202, a network interface (I/F) 203, a recording medium I/F 204, and a recording medium 205. The information processing apparatus 100 includes a display 206 and an input device 207. These components are coupled to one another via a bus 200.

The CPU 201 performs overall control of the information processing apparatus 100. The memory 202 includes, for example, a read-only memory (ROM), a random-access memory (RAM), a flash ROM, and the like. For example, the flash ROM or the ROM stores various programs, and the RAM is used as a work area for the CPU 201. The programs stored in the memory 202 are loaded by the CPU 201, thereby causing the CPU 201 to execute coded processing.

The network I/F 203 is coupled to a network 210 through a communication line and is coupled to another computer via the network 210. The network I/F 203 serves as an interface between the network 210 and inside of the information processing apparatus 100 and controls data input and output from and to the other computer. The network I/F 203 is, for example, a modem, a local area network (LAN) adapter, or the like.

The recording medium I/F 204 controls reading and writing of data from and to the recording medium 205 under the control of the CPU 201. The recording medium I/F 204 is, for example, a disk drive, a solid-state drive (SSD), a Universal Serial Bus (USB) port, or the like. The recording medium 205 is a nonvolatile memory that stores data written under the control of the recording medium I/F 204. The recording medium 205 is, for example, a disk, a semiconductor memory, a USB memory, or the like. The recording medium 205 may be removably attached to the information processing apparatus 100.

The display 206 displays a cursor, icons, toolboxes, documents, images, and data on functional information and the like. The display 206 is, for example, a cathode ray tube (CRT) display, a liquid crystal display, an electroluminescence (EL) display, or the like. The input device 207 includes keys for inputting characters, numbers, various instructions, and the like, and inputs data. An example of the input device 207 is a keyboard, a mouse, or the like. For example, the input device 207 may be a touch panel type input pad, a ten key pad, or the like.

Besides the components described above, the information processing apparatus 100 may also include, for example, a printer, a scanner, a microphone, a speaker, and the like. For example, the information processing apparatus 100 may include multiple recording medium I/Fs 204 and multiple recording media 205. For example, the information processing apparatus 100 does not have to include the display 206, the input device 207, or the like. For example, the information processing apparatus 100 does not have to include the recording medium I/F 204 and the recording medium 205.

### (Functional Configuration Example of Information Processing Apparatus 100)

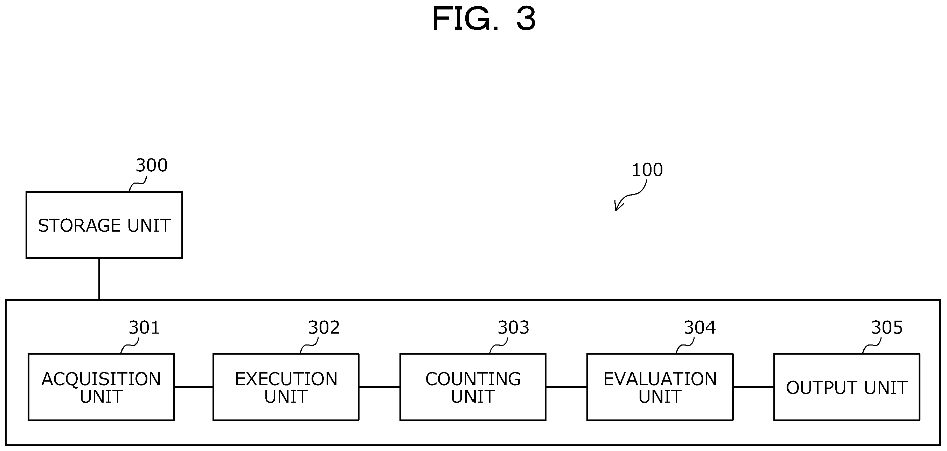

Next, a functional configuration example of the information processing apparatus 100 will be described using FIG. 3.

FIG. 3 is a block diagram illustrating a functional configuration example of the information processing apparatus 100. The information processing apparatus 100 includes a storage unit 300, an acquisition unit 301, an execution unit 302, a counting unit 303, an evaluation unit 304, and an output unit 305.

The storage unit 300 is implemented by, for example, a storage area such as the memory 202 or the recording medium 205 illustrated in FIG. 2. Although the following description will be given of a case where the storage unit 300 is included in the information processing apparatus 100, embodiments are not limited to this. For example, there may be a case where the storage unit 300 is included in an apparatus different from the information processing apparatus 100 and the information processing apparatus 100 is allowed to refer to data stored in the storage unit 300.

The acquisition unit 301 to the output unit 305 function as an example of a control unit. For example, the acquisition unit 301 to the output unit 305 implement their functions by causing the CPU 201 to execute a program stored in the storage area such as the memory 202 or the recording medium 205 illustrated in FIG. 2, or by using the network I/F 203. For example, a processing result of each functional unit is stored in the storage area such as the memory 202 or the recording medium 205 illustrated in FIG. 2.

The storage unit 300 stores various types of information to be referred to or updated in processing performed by each functional unit. For example, the storage unit 300 stores information on a target optimization problem. For example, the storage unit 300 stores one or more variables representing the target optimization problem. For example, the storage unit 300 stores a mathematical expression that enables calculation of each evaluation value of a provisional value or a candidate value for the solution to each of the variables representing a target optimization problem. Each evaluation value of the provisional value or the candidate value for the solution to the variable is also referred to as an energy, for example.

For example, the storage unit 300 stores information to be used during execution of predetermined optimization processing. For example, the predetermined optimization processing is a method of obtaining a combination of solutions to respective variables representing a target problem by iterating a step of performing the search process and the update process for each of the variables. The search process is a process of searching for a candidate value for the solution to the variable representing the target problem. For example, in the search process, a random value is set as the candidate value for the solution to the variable representing the target problem.

For example, the update process is a process of updating the provisional value of the solution to the variable representing the target problem with the candidate value. For example, in the update process, when the difference between the evaluation values of the provisional value and the candidate value for the solution to the variable representing the target problem is equal to or smaller than the first threshold, the provisional value of the solution to the variable is updated with the candidate value.

The first threshold is a threshold to be compared with the difference between the evaluation values of the provisional value and the candidate value for the solution to the variable representing the target problem. The first threshold is a threshold for determining whether or not to update the provisional value of the solution to the variable representing the target problem with the candidate value. For example, the first threshold is set in advance by a user of the information processing apparatus 100 or the like. For example, the first threshold is 0. Examples of the user include an operator who desires to execute the predetermined optimization processing, an administrator who administers the information processing apparatus 100, and the like.

For example, the update process is a process of updating the provisional value of the solution to the variable representing the target problem with the candidate value stochastically by using a random number when the difference between the evaluation values of the provisional value and the candidate value for the solution to the variable is greater than the first threshold. The random number is used to stochastically control whether or not to update the provisional value of the solution to the variable representing the target problem with the candidate value. For example, the random number is generated based on an integer value for generating the random number. For example, the integer value is set in advance by the user of the information processing apparatus 100 or the like.

For example, the predetermined optimization processing corresponds to the SA method. Among multiple steps of the predetermined optimization method, a step in which the provisional value of the solution to at least one of variables representing a target problem is updated with the candidate value may be referred to as an "update step" in the following description.

For example, the storage unit 300 stores the integer value for generating the random number.

For example, the storage unit 300 stores a parameter whose value increases as the number of previously-iterated steps increases. For example, the parameter is used together with the random number in order to control whether or not to stochastically update the provisional value of the solution to the variable representing the target problem with the candidate value. For example, the parameter is a value that has an initial value of 1, and that is doubled every time the number of previously-iterated steps increases by a certain number. For example, the parameter is set in advance by the user of the information processing apparatus 100 or the like.

### For example, the storage unit 300 stores the first threshold.

For example, the storage unit 300 stores the second threshold. The second threshold is a threshold to be compared with the difference between the evaluation values of the provisional value and the candidate value for the solution to the variable representing the target problem. The second threshold is variable. For example, the second threshold is a threshold depending on a resolution of the integer value for generating the random number. For example, the resolution specifies a maximum exponent of a reciprocal of a natural logarithm expressible by an integer value for generating the random number. For example, the second threshold is set based on the number of previously-iterated steps. For example, the second threshold is set based on the parameter whose value increases as the number of previously-iterated steps increases. For example, the second threshold is set to a quotient of the resolution of the integer value for generating the random number divided by the parameter whose value increases as the number of previously-iterated steps increases.

For example, the storage unit 300 stores a mathematical expression that enables calculation of the evaluation value of the difference between the evaluation values of the provisional value and the candidate value for the solution to the variable representing the target problem.

For example, the storage unit 300 stores a counter. For example, the counter is information for counting the number of times that the difference between the evaluation values of the provisional value and the candidate value for the solution to the variable representing the target problem becomes equal to or greater than the second threshold. For example, the counter is updated to indicate the number of times that the difference between the evaluation values of the provisional value and the candidate value for the solution to the variable representing the target problem becomes equal to or greater than the second threshold before the last step in which the provisional value of the solution to at least one of the variables representing the target problem is updated with the candidate value.

For example, the storage unit 300 stores the third threshold. For example, the third threshold is a threshold to be used for evaluating the appropriateness of the predetermined optimization processing for a target problem. For example, the third threshold is a threshold to be compared with the number of times that the difference between the evaluation values of the provisional value and the candidate value for the solution to the variable representing the target problem becomes equal to or greater than the second threshold. For example, the third threshold is 0. For example, the third threshold is set in advance by the user of the information processing apparatus 100 or the like.

The acquisition unit 301 acquires various types of information for use in processing performed by each functional unit. The acquisition unit 301 stores the acquired various types of information in the storage unit 300 or outputs the acquired various types of information to each functional unit. The acquisition unit 301 may output the various types of information stored in the storage unit 300 to each functional unit. For example, the acquisition unit 301 acquires various kinds of information based on an operation input by a user. For example, the acquisition unit 301 may receive various types of information from an apparatus different from the information processing apparatus 100.

For example, the acquisition unit 301 may acquire information on a target optimization problem and store the information in the storage unit 300. For example, the information on the target optimization problem contains one or more variables representing the target optimization problem. For example, the information on the target optimization problem contains a mathematical expression that enables calculation of each evaluation value of the provisional value or the candidate value for the solution to each of the variables representing the target optimization problem.

For example, the acquisition unit 301 acquires the information on the target optimization problem by accepting an input of the information on the target optimization problem based on an operation input by the user. For example, the acquisition unit 301 may acquire the information on the target optimization problem by receiving an input of the information from another computer.

For example, the acquisition unit 301 may acquire an evaluation request that requests an evaluation of the appropriateness of the predetermined optimization processing for a target optimization problem. There may be a case where the evaluation request contains the information on the target optimization problem. For example, the acquisition unit 301 acquires the evaluation request by accepting an input of the evaluation request based on an operation input by the user. For example, the acquisition unit 301 may acquire the evaluation request by receiving the evaluation request from another computer.

For example, the acquisition unit 301 may acquire the integer value for generating the random number and store the integer value in the storage section 300. For example, the acquisition unit 301 acquires the integer value for generating the random number by accepting an input of the integer value for generating the random number based on an operation input by the user. For example, the acquisition unit 301 may acquire the integer value for generating the random number by receiving the integer value from another computer.

For example, the acquisition unit 301 may acquire the parameter whose value increases as the number of previously-iterated steps increases, and store the parameter in the storage unit 300. For example, the acquisition unit 301 acquires the parameter by accepting an input of the parameter based on an operation input by the user. For example, the acquisition unit 301 may acquire the parameter by receiving the parameter from another computer.

For example, the acquisition unit 301 may acquire the first threshold and store the first threshold in the storage unit 300. For example, the acquisition unit 301 acquires the first threshold by accepting an input of the first threshold based on an operation input by the user. For example, the acquisition unit 301 may acquire the first threshold by receiving the first threshold from another computer.

For example, the acquisition unit 301 may acquire the mathematical expression that enables calculation of the evaluation value of the difference between the evaluation values of the provisional value and the candidate value for the solution to the variable representing the target problem, and store the mathematical expression in the storage unit 300. For example, the acquisition unit 301 acquires the mathematical expression by accepting an input of the mathematical expression that enables calculation of the evaluation value of the difference between the evaluation values of the provisional value and the candidate value for the solution to the variable representing the target problem based on an operation input by the user. For example, the acquisition unit 301 may acquire the mathematical expression that enables calculation of the evaluation value of the difference between the evaluation values of the provisional value and the candidate value for the solution to the variable representing the target problem, by receiving the mathematical expression from another computer.

For example, the acquisition unit 301 may acquire the third threshold and store the third threshold in the storage unit 300. For example, the acquisition unit 301 acquires the third threshold by accepting an input of the third threshold based on an operation input by the user. For example, the acquisition unit 301 may acquire the third threshold by receiving the third threshold from another computer.

The acquisition unit 301 may accept a start trigger for starting processing of any functional unit. For example, the start trigger is a predetermined operation input by the user. For example, the start trigger may be a reception of predetermined information from another computer. For example, the start trigger may be an output of predetermined information from any functional unit. The acquisition unit 301 may accept the acquisition of an evaluation request as the start trigger for starting the processing of the execution unit 302, the counting unit 303, and the evaluation unit 304.

The execution unit 302 executes the predetermined optimization processing. For example, the execution unit 302 executes the predetermined optimization processing by iterating the step of performing the search process and the update process for each of variables representing a target problem. For example, in a certain step, the execution unit 302 performs the search process for each of the variables representing the target problem. For example, in a certain step, the execution unit 302 generates a random value and sets the random value as the candidate value for the solution to any of the variables representing the target problem. In this way, the execution unit 302 may test various values as the candidate value for the solution to each of the variables representing the target problem.

For example, in a certain step, the execution unit 302 performs the update process for each of the variables representing the target problem. For example, in a certain step, the execution unit 302 determines whether or not the difference between the evaluation values of the provisional value and the candidate value for the solution to any of the variables representing the target problem is equal to or smaller than the first threshold. For example, when the difference between the evaluation values of the provisional value and the candidate value for the solution to any of the variables representing the target problem is equal to or smaller than the first threshold, the execution unit 302 updates the provisional value of the solution to the variable with the candidate value. Accordingly, the execution unit 302 may update the provisional value of the solution to any of the variables representing the target problem to a value closer to the value of the global optimal solution or the value of the local optimal solution.

For example, for any of the variables representing the target problem, the execution unit 302 acquires the parameter whose value increases as the number of previously-iterated steps increases when the difference between the evaluation values of the provisional value and the candidate value for the solution to the variable is greater than the first threshold. For example, for any of the variables representing the target problem, the execution unit 302 sets the product of the acquired parameter and the difference between the evaluation values of the provisional value and the candidate value for the solution to the variable, as the evaluation value of the difFerence.

For example, for any of the variables representing the target problem, the execution unit 302 determines whether or not the evaluation value of the difference between the evaluation values of the provisional value and the candidate value for the solution to the variable is equal to or greater than the random number. For example, for any of the variables representing the target problem, the execution unit 302 updates the provisional value of the solution to the variable with the candidate value when determining that the evaluation value of the difference between the evaluation values of the provisional value and the candidate value for the solution to the variable is equal to or greater than the random number.

For example, for any of the variables representing the target problem, the execution unit 302 does not update the provisional value of the solution to the variable with the candidate value when determining that the evaluation value of the difference between the evaluation values of the provisional value and the candidate value for the solution to the variable is smaller than the random number. In this way, the execution unit 302 may update the provisional value of the solution to any of the variables representing the target problem with the candidate value stochastically by using the random number. Thus, the execution unit 302 may make it easy to cause the provisional value of the solution to any of the variables representing the target problem to shift from the vicinity of the local optimal solution and approach to the global optimal solution.

In a certain step, the execution unit 302 may skip the update process for any of the variables representing the target problem. For example, the execution unit 302 acquires the second threshold. For example, in a certain step, the execution unit 302 sets the second threshold to the quotient of the resolution of the integer value for generating the random number divided by the parameter whose value increases as the number of previously-iterated steps increases.

For example, in a certain step, the execution unit 302 determines whether or not the difference between the evaluation values of the provisional value and the candidate value for the solution to any of the variables representing the target problem is equal to or greater than the second threshold. For example, in a certain step, when the difference between the evaluation values of the provisional value and the candidate value for the solution to any of the variables representing the target problem is equal to or greater than the second threshold, the execution unit 302 skips the update process for the variable.

For example, in a certain step, when the difference between the evaluation values of the provisional value and the candidate value for the solution to any of the variables representing the target problem is smaller than the second threshold, the execution unit 302 performs the update process for the variable. In this way, the execution unit 302 may appropriately determine whether or not to skip the update process based on the result of comparing the second threshold with the difference between the evaluation values of the provisional value and the candidate value for the solution to any of the variables representing the target problem. By skipping the update process, the execution unit 302 may reduce the processing load and the processing time for the predetermined optimization processing.

In executing the predetermined optimization processing, the counting unit 303 counts the number of times that the difference between the evaluation values of the provisional value and the candidate value for the solution to the variable representing the target problem becomes equal to or greater than the second threshold. For example, the counting unit 303 counts the number of times that the difference between the evaluation values of the provisional value and the candidate value for the solution to the variable representing the target problem becomes equal to or greater than the second threshold before the last update step in which the provisional value of the solution to at least one of the variables representing the target problem is updated with the candidate value.

For example, the last update step is the end update step out of one or more update steps in each of which the provisional value of the solution to at least one of the variables representing the target problem is updated with the candidate value, among multiple steps executed from the start to the end of the predetermined optimization processing.

For example, the counting unit 303 counts a total number of times that the difference between the evaluation values of the provisional value and the candidate value for the solution to each of the variables representing the target problem becomes equal to or greater than the second threshold before the last update step.

For example, in each step, the counting unit 303 increments the value of the counter every time the difference between the evaluation values of the provisional value and the candidate value for the solution to the variable representing the target problem becomes equal to or greater than the second threshold. For example, in each step, the counting unit 303 outputs the value of the counter when the provisional value of the solution to the variable representing the target problem is updated with the candidate value.

For example, after the predetermined optimization processing is executed, the counting unit 303 identifies the lastly output value of the counter, and sets the identified value as the total number of times that the difference between the evaluation values of the provisional value and the candidate value for the solution to each of the variables representing the target problem becomes equal to or greater than the second threshold before the last update step. In this way, the counting unit 303 may obtain the information to serve as a guide for evaluating the appropriateness of the predetermined optimization processing for the target problem.

For example, the counting unit 303 may count, as the number of times, the number of steps in which the difference between the evaluation values of the provisional value and the candidate value for the solution to at least one of the variables representing the target problem becomes equal to or greater than the second threshold before the last update step. In this way, the counting unit 303 may obtain the information to serve as a guide for evaluating the appropriateness of the predetermined optimization processing for the target problem.

After the predetermined optimization processing is executed, the evaluation unit 304 evaluates the appropriateness of the predetermined optimization processing for the target problem based on the counted number of times. For example, when the counted number of times is equal to or smaller than the third threshold, the evaluation unit 304 rates the predetermined optimization processing inappropriate for the target problem. For example, when the counted number of times is greater than the third threshold, the evaluation unit 304 rates the predetermined optimization processing appropriate for the target problem. In this way, the evaluation unit 304 may accurately evaluate the appropriateness of the predetermined optimization processing for the target problem. The evaluation unit 304 may reduce the work burden on an evaluator who evaluates the appropriateness of predetermined optimization processing for the target problem. The evaluator is, for example, the user.

The output unit 305 outputs a processing result of at least any functional unit. Examples of the output format include, for example, display on a display, print output to a printer, transmission to an external device via the network I/F 203, and storing in a storage area such as the memory 202 or the recording medium 205. Accordingly, the output unit 305 may enable the user to be notified of a processing result of at least any functional unit and achieve improvement in the convenience of the information processing apparatus 100.

The output unit 305 outputs a result of evaluation of the appropriateness of the predetermined optimization processing for a target problem by the evaluation unit 304. For example, the output unit 305 displays the result of evaluation of the appropriateness of the predetermined optimization processing for the target problem by the evaluation unit 304 on the display 206 so that the user may refer to the result. For example, the output unit 305 may transmit the result of evaluation of the appropriateness of the predetermined optimization processing for the target problem by the evaluation unit 304 to another computer. Thus, the output unit 305 enables the user to know the result of evaluation of the appropriateness of the predetermined optimization processing for the target problem by the evaluation unit 304.

### (Operation Example of Information Processing Apparatus 100)

Next, an operation example of the information processing apparatus 100 will be described. For evaluating the appropriateness of the SA method for a target problem, the information processing apparatus 100 actually performs the SA method for the target problem once. The SA method is executable in a shorter time than the other optimization methods are.

For example, the information processing apparatus 100 stores a parameter β. The parameter β is a value variable depending on the number of previously-iterated steps. The parameter β takes, for example, an initial value of 1. The parameter β is, for example, a multiplier of 2. The parameter β is a value doubled every time the number of previously-iterated steps increases by a certain number. For example, as the parameter β, values [1, 2, 4, 8, 16, 32, 64, ...] equally spaced on a logarithmic scale for the energy of the value of the solution to the variable representing the target problem are set in turn depending on the number of previously-iterated steps.

For example, the information processing apparatus 100 stores an N-bit integer value for generating a random number. For example, the information processing apparatus 100 stores a resolution RS of the N-bit integer value. The resolution RS is, for example, abs(log(1/2^N)). For example, the information processing apparatus 100 prepares one counter common to all the variables representing the target problem.

For example, for each of the variables representing the target problem, the information processing apparatus 100 generates the candidate value for the solution to the variable, and calculates the energy of the candidate value for the solution to the variable.
(2) For example, for each of the variables representing the target problem, the information processing apparatus 100 calculates an energy difference between the energy calculated this time and the energy of the current provisional value of the solution to the variable.
(3) For example, the information processing apparatus 100 sets the quotient of the resolution RS divided by the parameter β as a threshold TH. For example, for each of the variables representing the target problem, the information processing apparatus 100 determines whether or not the calculated energy difference ≥ the set threshold TH.
(4) For example, for any of the variables representing the target problem, when the calculated energy difference ≥ the set threshold TH, the information processing apparatus 100 determines that the provisional value of the solution to the variable does not have to be updated, and increments the value of the prepared counter. In this way, the information processing apparatus 100 may count the number of skips of the following processing in and after (5). In the following description, the skip of the following processing in and after (5) will be referred to as a "difFerence evaluation skip" in some cases.
(5) For example, for any of the variables representing the target problem, when the calculated energy difference < the set threshold TH, the information processing apparatus 100 determines whether or not the calculated energy difference ≤ 0.
(6) For example, for any of the variables representing the target problem, when the calculated energy difference ≤ 0, the information processing apparatus 100 updates the provisional value of the solution to the variable with the candidate value calculated this time for the solution to the variable. For example, when the provisional value of the solution to any of the variables representing the target problem is updated, the information processing apparatus 100 outputs the value of the counter.
(7) For example, for any of the variables representing the target problem, when the calculated energy difference > 0, the information processing apparatus 100 calculates an evaluation value of the calculated energy difference by multiplying the calculated energy difference by the parameter β. For example, for any of the variables representing the target problem, the information processing apparatus 100 generates a random number by using the integer value and determines whether or not the calculated evaluation value ≥ the calculated random number.
(8) For example, for any of the variables representing the target problem, when the calculated evaluation value ≥ the calculated random number, the information processing apparatus 100 updates the provisional value of the solution to the variable with the candidate value calculated this time for the solution to the variable. For example, when the provisional value of the solution to any of the variables representing the target problem is updated, the information processing apparatus 100 outputs the value of the counter.
(9) For example, for any of the variables representing the target problem, when the calculated evaluation value < the calculated random number, the information processing apparatus 100 does not update the provisional value of the solution to the variable.

For example, the information processing apparatus 100 executes the SA method by iterating the above exemplar processing in (1) to (9) as one step. For example, after executing the SA method, the information processing apparatus 100 sets the lastly output value of the counter as a "difFerence evaluation skip count during solution update". The term "during solution update" refers to a period from the first step of the SA method to the end step among one or more steps in each of which the provisional value for at least one of the variables representing the target problem is updated with the candidate value.

For example, the information processing apparatus 100 evaluates the appropriateness of the SA method for the target problem based on the set difference evaluation skip count during solution update. For example, the appropriateness corresponds to the solution accuracy of the SA method for the target problem. For example, the information processing apparatus 100 determines whether or not the set difference evaluation skip count during solution update ≤ 0. For example, when the difference evaluation skip count during solution update = 0, the information processing apparatus 100 rates the SA method inappropriate for the target problem, and rates the solution accuracy of the SA method low for the target problem.

For example, when the set difference evaluation skip count during solution update > 0, the information processing apparatus 100 rates the SA method appropriate for the target problem, and rates the solution accuracy of the SA method high for the target problem. In this way, the information processing apparatus 100 may make it easy for the user to evaluate the appropriateness of the SA method for the target problem. For example, the information processing apparatus 100 may enable the user to know the result of evaluation of the appropriateness of the SA method for the target problem based on the difference evaluation skip count during solution update.

For example, since the SA method is executable in a shorter time than the other optimization methods are, the information processing apparatus 100 may reduce the processing load and the processing time for evaluating the appropriateness of the SA method for a target problem. For example, the information processing apparatus 100 may enable a user to evaluate the appropriateness of the SA method for a target problem even when the user is not an expert and does not know detailed characteristics of the target problem. For example, the SA method is characterized in that a calculation time hardly becomes enormous even for a large-scale target problem. For this reason, even for a large-scale target problem, the information processing apparatus 100 may facilitate an evaluation of the appropriateness of the SA method for the target problem.

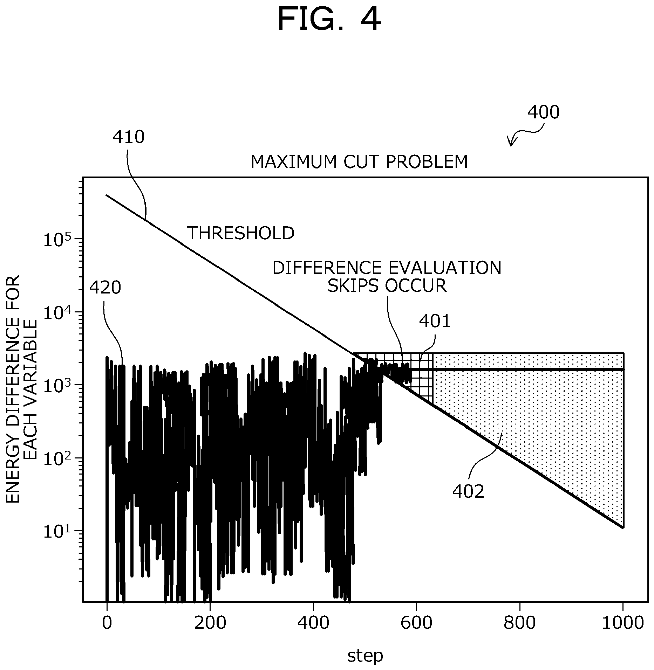

With reference to FIGs. 4 to 6, the following will describe cases where the information processing apparatus 100 evaluates the appropriateness of the SA method for problems of specific examples will be described, and explain that the difference evaluation skip count during solution update is usable as a criterion for evaluating the appropriateness of the SA method. First, for example, an example in which the information processing apparatus 100 evaluates the appropriateness of the SA method for a maximum cut problem will be described with reference to FIG. 4.

FIG. 4 is an explanatory diagram illustrating an example of evaluating the appropriateness of the SA method for a maximum cut problem. In FIG. 4, the information processing apparatus 100 executes the SA method on the maximum cut problem and evaluates the appropriateness of the SA method for the maximum cut problem as described above. A graph 400 presents each step in the SA method and a relationship between an energy difference for a first variable representing the maximum cut problem in the step and a threshold TH in the step.

In the graph 400, the threshold TH changes as indicated by a line 410. In the graph 400, the energy difference changes as indicated by a line 420. A region 401 indicates a first step range in which a difference evaluation skip may occur before the provisional value of the solution to each variable representing the maximum cut problem is no longer updated. A section ranging from step 0 to the end of the first step range corresponds to "during solution update". A region 402 indicates a second step range in which the provisional value of the solution to each variable representing the maximum cut problem is no longer updated and a difference evaluation skip may occur.

In the case where the SA method is executed on the maximum cut problem, difference evaluation skips occur during solution update in a state where there is still room for updating the provisional value of the solution to at least one of the variables representing the maximum cut problem with the candidate value as presented in the region 401 of the graph 400. Accordingly, in the case where the SA method is executed on the maximum cut problem, the difference evaluation skip count is considered to be 1 or more.

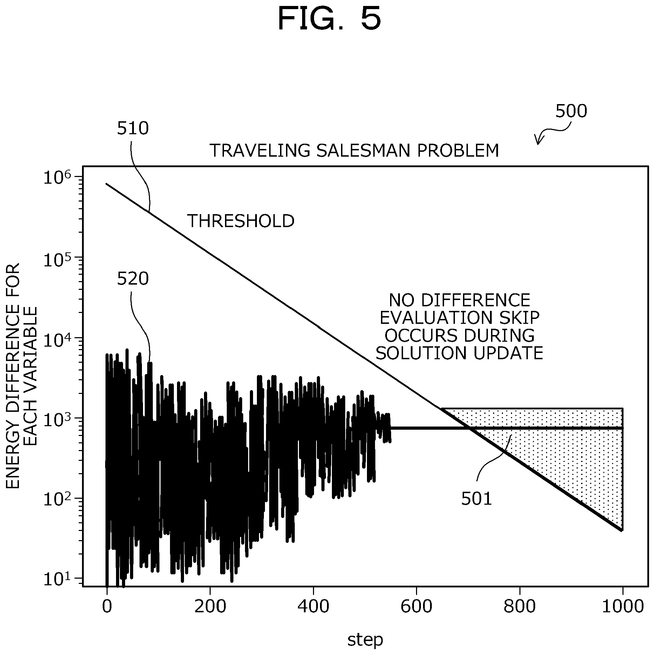

Next, for example, an example in which the information processing apparatus 100 evaluates the appropriateness of the SA method for a traveling salesman problem will be described with reference to FIG. 5.

FIG. 5 is an explanatory diagram illustrating an example of evaluating the appropriateness of the SA method for a traveling salesman problem. In FIG. 5, the information processing apparatus 100 executes the SA method on a traveling salesman problem and evaluates the appropriateness of the SA method for the traveling salesman problem as described above. A graph 500 presents each step in the SA method and a relationship between an energy difference for a first variable representing the traveling salesman problem in the step and a threshold TH in the step.

In the graph 500, the threshold TH changes as indicated by a line 510. In the graph 500, the energy difference changes as indicated by a line 520. A region 501 indicates a third step range in which the provisional value of the solution to each variable representing the traveling salesman problem is no longer updated and a difference evaluation skip may occur. A section ranging from step 0 to the head of the third step range in the graph 500 corresponds to "during solution update". In the graph 500, there is not any step range in which a difference evaluation skip may occur before the provisional value of the solution to each variable representing the traveling salesman problem is no longer updated.

In the case where the SA method is executed on the traveling salesman problem, any difference evaluation skip does not occur during solution update as illustrated in the graph 500. Accordingly, in the case where the SA method is executed on the traveling salesman problem, the difference evaluation skip count is considered to be 0.

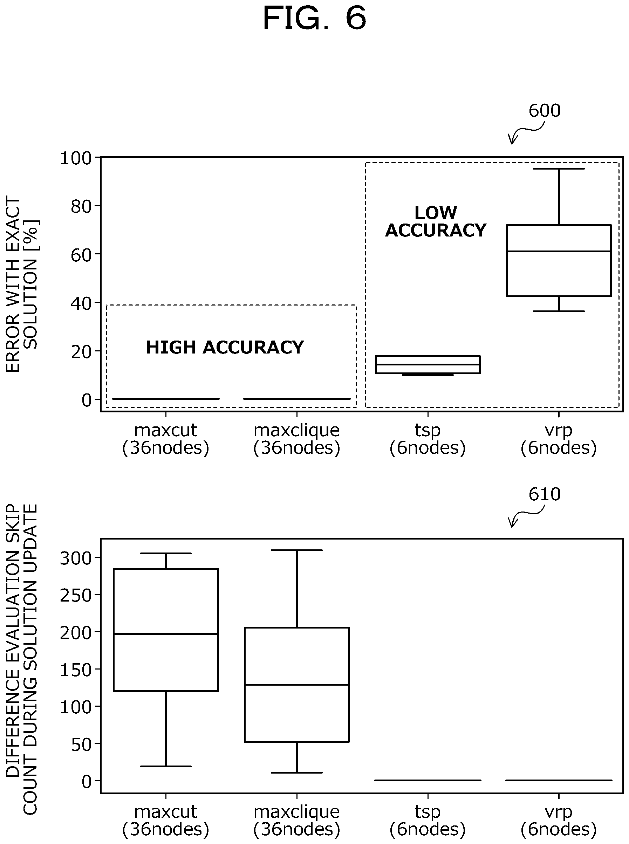

Next, an example of a relationship between the solution accuracy of the SA method and the difference evaluation skip count will be described with reference to FIG. 6. For example, FIG. 6 illustrates an example of a relationship between the solution accuracy of the SA method and the difference evaluation skip count in the case where the SA method is executed on multiple different types of optimization problems as illustrated in FIGs. 4 and 5.

FIG. 6 is an explanatory diagram illustrating an example of a relationship between the solution accuracy of the SA method and the difference evaluation skip count. In FIG. 6, a graph 600 presents a statistical value of solution accuracy by using a box-and-whisker plot in the case where the SA method is executed multiple times on each of problems maxcut, maxclique, tsp, and vrp.

The problem maxcut is a maximum cut problem. The problem maxclique is a maximum clique problem. The problem tsp is a traveling salesman problem. The problem vrp is a vehicle routing problem. The solution accuracy is represented by an error [%] between a solution obtained by the SA method and an exact solution.

As presented in the graph 600, the error of the SA method for maxcut is 0%, and the solution accuracy of the SA method is considered relatively high. Similarly, as presented in the graph 600, the error of the SA method for maxclique is 0%, and the solution accuracy of the SA method is considered relatively high.

On the other hand, as presented in the graph 600, the error of the SA method for tsp is greater than 0%, and the solution accuracy of the SA method is considered relatively low. For example, as presented in the box-and-whisker plot for tsp, the median value of the error in the SA method is a value corresponding to the position of the vertical center line of the box. The first quartile of the error in the SA method is a value corresponding to the position of the bottom line of the box. The third quartile of the error in the SA method is a value corresponding to the position of the top line of the box. The maximum value of the error in the SA method is a value corresponding to the position of a line on top of a line segment extending from the box. The minimum value of the error in the SA method is a value corresponding to the position of a line under a line segment extending from the box.

Similarly, as presented in the graph 600, the error of the SA method for vrp is greater than 0%, and the solution accuracy of the SA method is considered relatively low. For example, as presented in the box-and-whisker plot for vrp, the median value of the error in the SA method is a value corresponding to the position of the vertical center line of the box. The first quartile of the error in the SA method is a value corresponding to the position of the bottom line of the box. The third quartile of the error in the SA method is a value corresponding to the position of the top line of the box. The maximum value of the error in the SA method is a value corresponding to the position of a line on top of a line segment extending from the box. The minimum value of the error in the SA method is a value corresponding to the position of a line under a line segment extending from the box.

A graph 610 presents a statistical value of the difference evaluation skip count by using a box-and-whisker plot in the case where the SA method is executed multiple times on each of the problems maxcut, maxclique, tsp, and vrp.

As presented in the graph 610, the difference evaluation skip count in the SA method for maxcut is greater than 0. For example, as presented in the box-and-whisker plot for maxcut, the median value of the difference evaluation skip count is a value corresponding to the position of the vertical center line of the box. The first quartile of the difference evaluation skip count is a value corresponding to the position of the bottom line of the box. The third quartile of the difference evaluation skip count is a value corresponding to the position of the top line of the box. The maximum value of the difference evaluation skip count is a value corresponding to the position of the line on top of a line segment extending from the box. The minimum value of the difference evaluation skip count is a value corresponding to the position of the line under a line segment extending from the box.

Similarly, as presented in the graph 610, the difference evaluation skip count in the SA method for maxclique is greater than 0. For example, as presented in the box-and-whisker plot for maxclique, the median value of the difference evaluation skip count is a value corresponding to the position of the vertical center line of the box. The first quartile of the difference evaluation skip count is a value corresponding to the position of the bottom line of the box. The third quartile of the difference evaluation skip count is a value corresponding to the position of the top line of the box. The maximum value of the difference evaluation skip count is a value corresponding to the position of the line on top of a line segment extending from the box. The minimum value of the difference evaluation skip count is a value corresponding to the position of the line under a line segment extending from the box.

On the other hand, as presented in the graph 610, the difference evaluation skip count in the SA method for tsp is 0. Similarly, as presented in the graph 610, the difference evaluation skip count in the SA method for vrp is 0. As described above, it is considered that the difference evaluation skip count tends to be greater than 0 when the solution accuracy of the SA method is relatively high. On the other hand, it is considered that the difference evaluation skip count tends to be equal to 0 when the solution accuracy of the SA method is relatively low.

Accordingly, it is considered that the information processing apparatus 100 may estimate whether or not the solution accuracy of the SA method for a target problem is high based on whether the difference evaluation skip count in the case where the SA method is executed for the target problem is equal to 0 or greater than 0. For this reason, it is considered that the information processing apparatus 100 may evaluate the appropriateness of the SA method for a target problem based on the difference evaluation skip count in the case where the SA method is executed for the target problem.

### (Solving Processing Procedure)

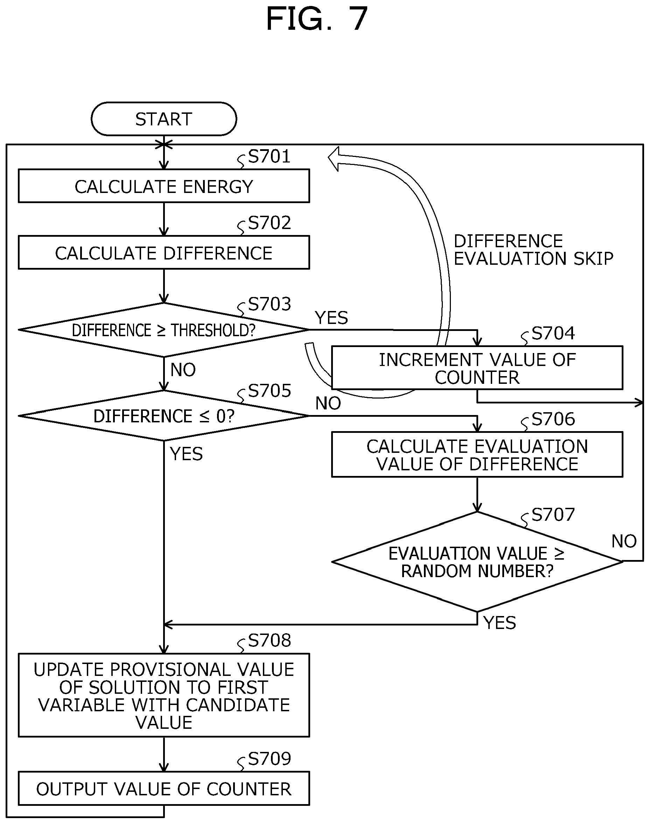

Next, an example of a solving processing procedure executed by the information processing apparatus 100 will be described with reference to FIG. 7. Solving processing is implemented, for example, by the CPU 201, a storage area such as the memory 202 or the recording medium 205, and the network I/F 203 illustrated in FIG. 2.

For example, the solving processing is executed for each of variables representing a target problem. The following description will be given of a case where the solving processing is executed for a first variable representing the target problem.

FIG. 7 is a flowchart illustrating an example of the solving processing procedure. In FIG. 7, the information processing apparatus 100 generates a candidate value for the solution to the first variable, and calculates the energy of the generated candidate value for the solution to the first variable (step S701). The information processing apparatus 100 calculates the difference between the currently-calculated energy of the candidate value for the solution to the first variable and the previously-calculated energy of the current provisional value of the solution to the first variable (step S702).

Next, the information processing apparatus 100 calculates the threshold by dividing the resolution by the parameter β, and determines whether or not the calculated difference ≥ the calculated threshold (step S703). When the difference ≥ the threshold (step S703: Yes), the information processing apparatus 100 proceeds to processing in step S704. On the other hand, when the difference < the threshold (step S703: No), the information processing apparatus 100 proceeds to processing in step S705.

In step S704, the information processing apparatus 100 increments the value of the counter (step S704). The counter is commonly used for all the variables representing the target problem. The information processing apparatus 100 returns to the processing in step S701.

In step S705, the information processing apparatus 100 determines whether or not the calculated difference ≤ 0 (step S705). When the difference > 0 (step S705: No), the information processing apparatus 100 proceeds to processing in step S706. On the other hand, when the difference ≤ 0 (step S705: Yes), the information processing apparatus 100 proceeds to processing in step S708.

In step S706, the information processing apparatus 100 calculates the evaluation value of the calculated difference by multiplying the calculated difference by the parameter β (step S706). The information processing apparatus 100 generates the random number by using the integer value, and determines whether or not the calculated evaluation value ≥ the random number (step S707). When the evaluation value < the random number (step S707: No), the information processing apparatus 100 returns to the processing in step S701. On the other hand, when the evaluation value ≥ the random number (step S707: Yes), the information processing apparatus 100 proceeds to the processing in step S708.

In step S708, the information processing apparatus 100 updates the provisional value of the solution to the first variable with the currently-calculated candidate value for the solution to the first variable (step S708). After that, the information processing apparatus 100 outputs the value of the counter (step S709). The information processing apparatus 100 returns to the processing in step S701.

In this way, the information processing apparatus 100 may obtain the solution to the first variable representing the target problem. One step of the SA method is to end one loop of returning to step S701 in the solving processing for each variable representing a target problem. After ending one loop of returning to step S701 of the solving processing for each variable representing the target problem, the information processing apparatus 100 starts the next loop of returning to step S701 of the solution processing for each variable representing the target problem.

### (Evaluation Processing Procedure)

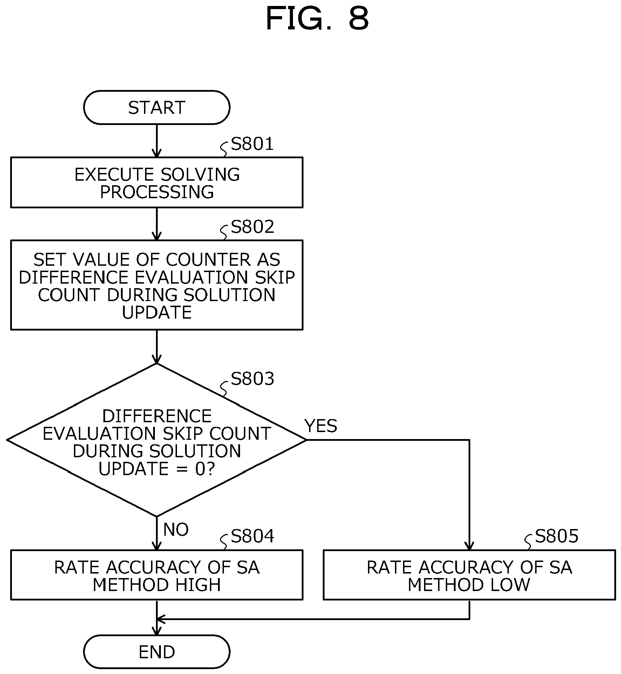

Next, an example of an evaluation processing procedure executed by the information processing apparatus 100 will be described next with reference to FIG. 8. Evaluation processing is implemented, for example, by the CPU 201, the storage area such as the memory 202 or the recording medium 205, and the network I/F 203 illustrated in FIG. 2.

FIG. 8 is a flowchart illustrating an example of the evaluation processing procedure. In FIG. 8, the information processing apparatus 100 executes the solving processing illustrated in FIG. 7 (step S801). Next, the information processing apparatus 100 specifies the lastly output value of the counter and sets the identified value of the counter as the difference evaluation skip count during solution update (step S802).

The information processing apparatus 100 determines whether or not the set difference evaluation skip count during solution update = 0 (step S803). When the difference evaluation skip count > 0 (step S803: No), the information processing apparatus 100 proceeds to processing in step S804. On the other hand, when the difference evaluation skip count = 0 (step S803: Yes), the information processing apparatus 100 proceeds to processing in step S805.

In step S804, the information processing apparatus 100 rates the accuracy of the SA method high (step S804). The information processing apparatus 100 ends the evaluation processing.

In step S805, the information processing apparatus 100 rates the accuracy of the SA method low (step S805). The information processing apparatus 100 ends the evaluation processing. In this way, the information processing apparatus 100 may facilitate an evaluation of the appropriateness of the SA method for a target problem.

The information processing apparatus 100 may partially change the processing order of some of the steps illustrated in each of the flowcharts of FIGs. 7 and 8. The information processing apparatus 100 may skip the processing in one or some of the steps illustrated in each of the flowcharts of FIGs. 7 and 8.

As described above, according to the information processing apparatus 100, it is possible to execute the optimization processing on a target problem including iterating the step of performing the search process and the update process for each of variables representing the target problem. According to the information processing apparatus 100, it is possible to count the number of times that the difference between the evaluation values of the provisional value and the candidate value for the solution to the variable becomes equal to or greater than the second threshold depending on the resolution of the integer value for generating the random number before the last step in which the provisional value of the solution to at least one variable is updated with the candidate value. According to the information processing apparatus 100, it is possible to evaluate the appropriateness of the optimization processing for the target problem based on the counted number of times. In this way, the information processing apparatus 100 may make it easy for the user to evaluate the appropriateness of the optimization processing for a target problem. The information processing apparatus 100 may reduce the processing load and the processing time for evaluating the appropriateness of the optimization processing for a target problem.

According to the information processing apparatus 100, in a step of the optimization processing, it is possible to skip the update process for any of the variables representing a target problem when the difference between the evaluation values of the provisional value and the candidate value for the solution to the variable is equal to or greater than the second threshold. According to the information processing apparatus 100, it is possible to perform the update process for the variable when the difference is smaller than the second threshold. In this way, the information processing apparatus 100 may reduce the processing load and the processing time for evaluating the appropriateness of the optimization processing for a target problem.

According to the information processing apparatus 100, it is possible to rate the optimization processing inappropriate for the target problem when the counted number of times is equal to or smaller than the third threshold. According to the information processing apparatus 100, it is possible to rate the optimization processing appropriate for the target problem when the counted number of times is greater than the third threshold. In this way, the information processing apparatus 100 may accurately evaluate whether or not the optimization processing is appropriate for a target problem.

According to the information processing apparatus 100, in a step of the optimization processing, it is possible to set the second threshold to the quotient of the resolution divided by the parameter whose value increases as the number of previously-iterated steps before the current step increases. In this way, the information processing apparatus 100 may appropriately set the second threshold, and make it easy to accurately determine whether or not it is suitable to skip the update process.

According to the information processing apparatus 100, when the difference between the evaluation values of the provisional value and the candidate value for the solution to each of the variables is greater than the first threshold, it is possible to determine whether or not the product of the difference and the parameter whose value increases as the number of previously-iterated steps increases is equal to or smaller than the random number. According to the information processing apparatus 100, it is possible to update the provisional value of the solution to the variable with the candidate value when the product is equal to or smaller than the random number. According to the information processing apparatus 100, it is possible to skip updating of the provisional value of the solution to the variable with the candidate value when the product is greater than the random number. In this way, the information processing apparatus 100 may reduce the processing load and the processing time for the optimization processing.

According to the information processing apparatus 100, it is possible to count the total number of times that the difference between the evaluation values of the provisional value and the candidate value for the solution to each of the variables becomes equal to or greater than the second threshold before the last step in which the provisional value of the solution to at least one of the variables is updated with the candidate value. Thus, the information processing apparatus 100 may use the number of times on a variable-by-variable basis.

According to the information processing apparatus 100, in each step of the optimization processing, it is possible to increment the value of the counter every time the difference between the evaluation values of the provisional value and the candidate value for the solution to the variable representing the target problem becomes equal to or greater than the second threshold. According to the information processing apparatus 100, it is possible to output the value of the counter when the provisional value of the solution to the variable representing the target problem is updated with the candidate value. According to the information processing apparatus 100, it is possible to set the lastly output value of the counter as the number of times after the optimization processing is executed. In this way the information processing apparatus 100 may appropriately count the number of times while executing the optimization processing.

According to the information processing apparatus 100, it is possible to count, as the number of times, the number of steps in each of which the difference between the evaluation values of the provisional value and the candidate value for the solution to at least one of the variables becomes equal to or greater than the second threshold before the last step in which the provisional value of the solution to at least one of the variables is updated with the candidate value. Thus, the information processing apparatus 100 may use the number of times on a step-by-step basis.

According to the information processing apparatus 100, it is possible to adopt 0 as the first threshold. Thus, the information processing apparatus 100 may make it easy to set an appropriate value for the first threshold according to the rule of thumb, and accurately determine whether or not it is suitable to update the provisional value of the solution to each variable with the candidate value.

According to the information processing apparatus 100, it is possible to adopt 0 as the third threshold. Thus, the information processing apparatus 100 may make it easy to an appropriate value for the third threshold according to the rule of thumb, and accurately evaluate the appropriateness of the optimization processing for a target problem.

The evaluation support method described in the present embodiment may be implemented by a computer such as a personal computer (PC) or a workstation executing a previously prepared program. The evaluation support program described in the present embodiment is recorded in a computer-readable recording medium, and is read from the recording medium and executed by a computer. The recording medium is a hard disk, a flexible disk, a compact disc (CD)-ROM, a magneto optical (MO) disc, a Digital Versatile Disc (DVD), or the like. The evaluation support program described in the present embodiment may be distributed via a network such as the Internet.

In relation to the embodiment described above, appendices below are further disclosed.

## Claims

1. An evaluation program comprising instructions which when executed by a computer, cause the computer to perform processing comprising:
executing optimization processing of iterating a step of performing a search process and an update process for each variable that represents a target problem, in which the search process includes searching for a candidate value for a solution to the variable that represents the target problem, and in which the update process includes updating a provisional value of the solution to the variable with the candidate value when a difference between evaluation values of the provisional value and the candidate value for the solution to the variable is equal to or smaller than a first threshold, and updating the provisional value of the solution to the variable with the candidate value stochastically by using a random number when the difference between the evaluation values of the provisional value and the candidate value for the solution to the variable is greater than the first threshold;
in executing the optimization processing, counting the number of times that the difference between the evaluation values of the provisional value and the candidate value for the solution to the variable that represents the target problem becomes equal to or greater than a second threshold depending on a resolution of an integer value for generating the random number before the last step in which the provisional value of the solution to at least one variable that represents the target problem is updated with the candidate value; and
after executing the optimization processing, evaluating an appropriateness of the optimization processing for the target problem based on the counted number of times.

2. The non-transitory computer-readable recording medium according to claim 1, wherein
the executing of the optimization processing includes
skipping the update process for any variable that represents the target problem when the difference between the evaluation values of the provisional value and the candidate value for the solution to the variable is equal to or greater than the second threshold, or
performing the update process for the variable when the difference is smaller than the second threshold.

3. The non-transitory computer-readable recording medium according to claim 1 or 2, wherein
the evaluating of the appropriateness includes
rating the optimization processing inappropriate for the target problem when the counted number of times is equal to or smaller than a third threshold, and
rating the optimization processing appropriate for the target problem when the counted number of times is greater than the third threshold.

4. The non-transitory computer-readable recording medium according to claim 1 or 2, wherein
the executing of the optimization processing includes setting the second threshold to a quotient of the resolution divided by a parameter whose value increases as the number of previously-iterated steps before the current step increases.

5. The non-transitory computer-readable recording medium according to claim 1 or 2, wherein
the update process includes,
when the difference between the evaluation values of the provisional value and the candidate value for the solution to the variable that represents the target problem is greater than the first threshold, determining whether or not a product of the difference and a parameter whose value increases as the number of previously-iterated steps increases is equal to or smaller than the random number,
updating the provisional value of the solution to the variable with the candidate value when the product is equal to or smaller than the random number, and
skipping updating of the provisional value of the solution to the variable with the candidate value when the product is greater than the random number.

6. The non-transitory computer-readable recording medium according to claim 1 or 2, wherein
the counting includes
in executing the optimization processing, counting a total number of times that the difference between the evaluation values of the provisional value and the candidate value for the solution to each variable that represents the target problem becomes equal to or greater than the second threshold before the last step in which the provisional value of the solution to at least one of the variables that represents the target problem is updated with the candidate value.

7. The non-transitory computer-readable recording medium according to claim 6, wherein
the counting includes
in each step of the optimization processing,
incrementing a value of a counter every time the difference between the evaluation values of the provisional value and the candidate value for the solution to the variable that represents the target problem becomes equal to or greater than the second threshold,
outputting the value of the counter when the provisional value of the solution to the variable that represents the target problem is updated with the candidate value, and
setting the lastly output value of the counter as the number of times after executing the optimization processing.

8. An evaluation method implemented by a computer, the evaluation method comprising:
executing optimization processing of iterating a step of performing a search process and an update process for each variable that represents a target problem, in which the search process includes searching for a candidate value for a solution to the variable that represents the target problem, and in which the update process includes updating a provisional value of the solution to the variable with the candidate value when a difference between evaluation values of the provisional value and the candidate value for the solution to the variable is equal to or smaller than a first threshold, and updating the provisional value of the solution to the variable with the candidate value stochastically by using a random number when the difference between the evaluation values of the provisional value and the candidate value for the solution to the variable is greater than the first threshold;
in executing the optimization processing, counting the number of times that the difference between the evaluation values of the provisional value and the candidate value for the solution to the variable that represents the target problem becomes equal to or greater than a second threshold depending on a resolution of an integer value for generating the random number before the last step in which the provisional value of the solution to at least one variable that represents the target problem is updated with the candidate value; and
after executing the optimization processing, evaluating an appropriateness of the optimization processing for the target problem based on the counted number of times.

9. An information processing apparatus comprising a control unit configured to perform processing including:
executing optimization processing of iterating a step of performing a search process and an update process for each variable that represents a target problem, in which the search process includes searching for a candidate value for a solution to the variable that represents the target problem, and in which the update process includes updating a provisional value of the solution to the variable with the candidate value when a difference between evaluation values of the provisional value and the candidate value for the solution to the variable is equal to or smaller than a first threshold, and updating the provisional value of the solution to the variable with the candidate value stochastically by using a random number when the difference between the evaluation values of the provisional value and the candidate value for the solution to the variable is greater than the first threshold;
in executing the optimization processing, counting the number of times that the difference between the evaluation values of the provisional value and the candidate value for the solution to the variable that represents the target problem becomes equal to or greater than a second threshold depending on a resolution of an integer value for generating the random number before the last step in which the provisional value of the solution to at least one variable that represents the target problem is updated with the candidate value; and
after executing the optimization processing, evaluating an appropriateness of the optimization processing for the target problem based on the counted number of times.
